# EUROPÄISCHE PATENTSCHRIFT

(11) **EP 0 419 898 B1**
(45) Veröffentlichungstag und Bekanntmachung des Hinweises auf die Patenterteilung: **31.05.2000**
(21) Anmeldenummer: 90117012.6
(22) Anmeldetag: 04.09.1990
(51) Int. Cl.: H01L 21/332, H01L 21/331, H01L 21/263, H01L 21/225, H01L 21/266, H01L 29/32, H01L 29/167, H01L 29/74

(54) **Verfahren zur Erhöhung der Spannungsfestigkeit eines mehrschichtigen Halbleiterbauelements**
Method of enhancing the withstand voltage of a multilayered semiconductor device
Méthode pour augmenter la tenue en tension d'un dispositif semi-conducteur à plusieurs couches

(30) Priorität: 28.09.1989 DE 3932489
(43) Veröffentlichungstag der Anmeldung: 03.04.1991
(60) Teilanmeldung: 97122692.3
(73) Patentinhaber: SIEMENS AKTIENGESELLSCHAFT, 80333 München (DE)
(72) Erfinder: Schulze, Hans-Joachim, Dr., D-8012 Ottobrunn (DE); Mitlehner, Heinz, Dr., D-8000 München 40 (DE)

(56) Entgegenhaltungen:
- DE-A- 2 738 152
- US-A- 4 043 837
- US-A- 4 177 477
- US-A- 4 792 530
- SOLID STATE ELECTRONICS, Bd.30, Nr.2, Februar 1987, OXFORD GB Seiten 185 - 188 A. MOGRO-CAMPERO ET AL
- CONFERENCE RECORD, IEEE INDUSTRY APPLICATIONS SOC., ANNUAL MEETING, 18. Oktober 1987, ATLANTA, GEORGIA Seiten 531 - 536 J. VITINS ET AL

## Beschreibung

Verfahren zur Erhöhung der Spannungsfestigkeit eines mehrschichtigen Halbleiterbauelements.

Die Erfindung bezieht sich auf Verfahren zur Erhöhung der Spannungsfestigkeit eines mehrschichtigen Halbleiterbauelementes nach dem Oberbegriff des Patentanspruchs 1.

Einige Verfahren dieser Art sind in dem Buch von W. Gerlach 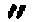 Thyristoren", erschienen als Band 12 der Buchreihe 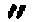 Halbleiter-Elektronik", herausgegeben von W. Heywang und R. Müller im Springer-Verlag, Berlin 1979, auf den Seiten 151 bis 159 beschrieben. Dort sind insbesondere in den Bildern 4.22 und 4.23 scheibenförmige Thyristoren gezeigt, deren Ränder in den Bereichen der in Sperrichtung vorgespannten pn-Übergänge jeweils positiv oder negativ abgeschrägt sind. Auf den Seiten 158 und 159 dieser Veröffentlichung ist eine andere Methode angegeben, bei der der in Sperrichtung vorgespannte pn-Übergang planar ausgeführt und durch einen oder mehrere konzentrische Feldbegrenzungsringe ergänzt ist, wobei letztere wie ein Spannungsteiler an der Oberfläche des Thyristors wirken und die Oberflächenfeldstärke soweit herabsetzen, daß ein Oberflächendurchbruch bis zu sehr hohen Sperrvorspannungen des pn-Übergangs vermieden wird.

Aus der deutschen Offenlegungsscshrift DE 27 38 152 A1 ist ein Festkörperbauelement, insbesondere ein Thyristor, bekannt, bei dem ein gesamter Bereich außerhalb der Steuerelektrode in seiner Ladungsträgerlebensdauer gegenüber dem Bereich unterhalb der Steuerelektrode abgesenkt ist, wobei die Absenkung nur so groß ist, daß das Bauelement zündfähig bleibt.

Der Erfindung liegt die Aufgabe zugrunde, Verfahren der eingangs genannten Art anzugeben, die eine deutliche Anhebung der Spannungsfestigkeit gewährleisten. Das wird erfindungsgemäß durch eine Ausgestaltung nach dem Patentanspruch 1 erreicht.

Das erfindungsgemäße Verfahren zeichnet sich insbesondere dadurch aus, daß sie in einfacher Weise, nämlich durch eine entsprechende Einstellung der Bestrahlungsenergie und -dosis, eine quantitativ einstellbare Erhöhung der Spannungsfestigkeit ermöglichen. Insbesondere können sie auf solche Halbleiterbauelemente angewendet werden, deren Spannungsfestigkeit schon nach den bekannten Verfahren erhöht wurde, um eine weitere Erhöhung derselben zu erreichen.

Die Erfindung wird nachfolgend anhand der Zeichnung näher erläutert. Dabei zeigt:
- Figur 1: die Anwendung eines ersten erfindungsgemäßen Verfahrens auf einen Thyristor,
- Figur 2: die Anwendung des ersten erfindungsgemäßen Verfahrens auf einen planaren Transistor.

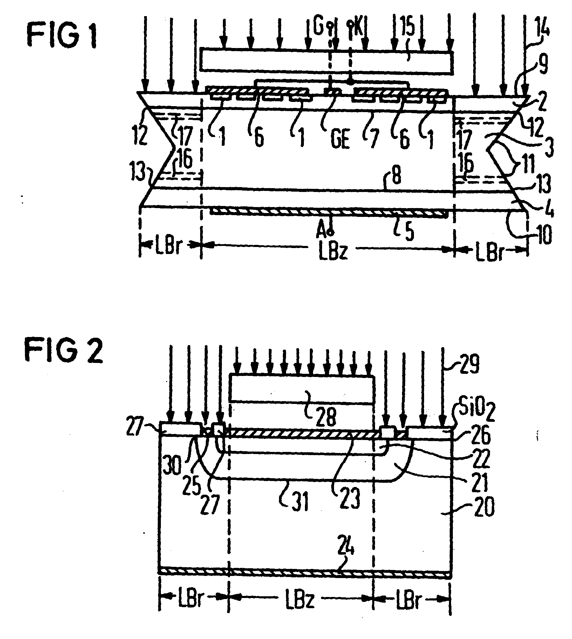

In Figur 1 ist ein Thyristor mit einem aus dotiertem Halbleitermaterial, zum Beispiel Silizium, bestehenden Halbleiterkörper dargestellt. Er weist vier aufeinanderfolgende Schichten abwechselnder Leitungstypen auf. Von diesen bezeichnet man die aus den n-leitenden Teilschichten 1 bestehende Schicht als den n-Emitter, die p-leitende Schicht 2 als die p-Basis, die n-leitende Schicht 3 als die n-Basis und die p-leitende Schicht 4 als den p-Emitter. Der p-Emitter ist mit einer anodenseitigen Elektrode 5 aus elektrisch leitendem Material, zum Beispiel Al, versehen, die einen Anschluß A aufweist. Der n-Emitter ist mit einer kathodenseitigen Elektrode 6 versehen, die die Teilschichten 1 kontaktiert und mit einem Anschluß K versehen ist. Beim dargestellten Ausführungsbeispiel kontaktiert 6 auch die Schicht 2 zur Bildung von Emitterkurzschlüssen. Der Anschluß G einer Gateelektrode GE, die die p-Basis kontaktiert, wird zum Zünden des Thyristors in an sich bekannter Weise mit einem positiven Zündstromimpuls beaufschlagt.

Wird an die Anschlüsse A und K eine Spannung geschaltet, die die Elektrode 5 auf ein positiveres Potential legt als die Elektrode 6, so wird der pn-Übergang 7 zwischen den Schichten 2 und 3 in Sperrichtung vorgespannt. Wenn andererseits bei A und K eine Spannung angeschaltet ist, die die Elektrode 5 auf ein negativeres Potential legt als die Elektrode 6, so wird der pn-Übergang 8 zwischen den Schichten 3 und 4 in Sperichtung vorgespannt. Um eine hohe Spannungsfestigkeit des Thyristors zu gewährleisten, muß dafür Sorge getragen werden, daß ein oberflächenseitiger Durchbruch der pn-Übergänge 7 und 8 erst bei hohen Sperrspannungen eintritt. Zu diesem Zweck wird der Thyristorrand zum Beispiel, wie in Figur 1 dargestellt, sowohl von der oberen Hauptfläche 9 als auch von der unteren Hauptfläche 10 ausgehend jeweils mit einem positiven Winkel abgeschrägt. Damit wird eine Absenkung der Qberflächenfeldstärke im Bereich der in der seitlichen Begrenzungsfläche 11 liegenden seitlichen Randabschlüsse 12 und 13 der pn-Übergänge 7 und 8 erreicht, durch die die Gefahr des Durchbruchs an dieser Stelle herabgesetzt wird.

Nach dem erfindungsgemäßen Verfahren wird nun lediglich im lateralen Bereich LBr der seitlichen Randabschlüsse 12 und 13 die Trägerlebensdauer durch eine Bestrahlung mit Protonen reduziert, was in Figur 1 durch vertikale Pfeile 14 angedeutet ist. Durch eine Abdeckung des lateralen Bereichs LBz, also des zentralen Bereichs des Halbleiterbauelements, mit einer Bestrahlungsmaske 15, zum Beispiel aus Metall, wird erreicht, daß sich die Reduzierung der Trägerlebensdauer, die sich zum Beispiel von 200 µs auf 10 µs verringert, lediglich innerhalb von LBr vollzieht. Damit verringert sich innerhalb von LBr auch der Stromverstärkungsfaktor αₚₙₚ, was eine erhöhte Spannungsfestigkeit in diesem Bereich zur Folge hat.

Dabei ergibt sich der insbesondere für eine vertikale Schichtenfolge bedeutsame Vorteil, daß sich durch die Wahl einer bestimmten Bestrahlungsenergie,zum Beispiel 10 MeV, eine dünne Zon 16 verringerter Trägerlebensdauer ergibt, die in einer von der Bestrahlungsenergie abhängigen Entfernung von der Hauptfläche 9 etwa parallel zu dieser verläuft. Legt man die Zone 16 gemäß Figur 1 in die bei angelegter voller Kippspannung neutrale Zone der n-Basis, also außerhalb der sich infolge der Sperrvorspannung am pn-übergang 7 aufbauenden Raumladungszone, so wird eine besonders starke Anhebung der Spannungsfestigkeit in Blockierrichtung erzielt.

Um die Spannungsfestigkeit in Sperrichtung zu verbessern, empfiehlt es sich, die Trägerlebensdauer in einer Zone 17 durch Protonenbestrahlung abzusenken, wobei diese Zone vorzugsweise in der bei angelegter Sperrspannung neutralen Zone der n-Basis 3 liegen sollte, also außerhalb der sich infolge der Sperrspannung am pn-Übergang 8 aufbauenen Raumladungszone.

Der Vorteil der durch Protonenbestrahlung erzielten, sich im wesentlichen auf die mit 16 bzw. 17 bezeichneten, diskreten Zonen beschränkenden, reduzierten Trägerlebensdauer gegenüber der bei der Elektronenbestrahlung innerhalb von LBr homogen reduzierten Trägerlebensdauer liegt in der effektiveren Absenkung des Verstärkungsfaktors αₚₙₚ aufgrund des verbesserten Verhältnisses zwischen der durch die Bestrahlung erzeugten Rekombinationsrate und der Generationsrate freier Ladungsträger bei bestehender Raumladungszone.

Die Bestrahlung mit Protonen kann sowohl von der Kathodenseite als auch von der Anodenseite her erfolgen und insbesondere auch von beiden Stellen, was unter Umständen dann zweckmäßig sein kann, wenn beide Zonen 16 und 17 vorgesehen werden sollen.

Figur 2 zeigt die Anwendung des erfindungsgemäßen Verfahrens auf einen planaren Transistor. Dieser besteht zum Beispiel aus einer n-leitenden Schicht 20, einer in diese eingebetteten p-leitenden Schicht 21 und einer in diese eingefügten n-leitenden Schicht 22, die jeweils den Kollektor, die Basis und den Emitter darstellen. Der Emitter ist mit einer Emitterelektrode 23 versehen, der Kollektor mit einer Kollektorelektrode 24 und die Basis mit einer Basiselektrode 25, wobei die Anschlüsse dieser Elektroden aus Gründen einer einfachen Darstellung nicht gezeigt sind. Die erste Hauptfläche 26 ist zwischen den Elektroden 23 und 25 mit einer Passivierungsschicht 27, zum Beispiel aus SiO₂, versehen. Nach Anbringung einer Bestrahlungsmaske 28, die den zentralen Bereich LBz des Transistors abdeckt, erfolgt eine durch die Pfeile 29 angedeutete Bestrahlung mit Protonen. Diese bewirken im Bereich LBr des Randabschlusses 30 des pn-Übergangs 31 zwischen dem Kollektor 20 und der Basis 21 eine Reduzierung der Trägerlebensdauer und damit eine deutliche Erhöhung der Spannungsfestigkeit des Transistors gegenüber einer bei 23 und 24 anliegenden Spannung, die die Kollektorelektrode 24 auf ein positiveres Potential legt als die Emitterelektrode 23 und die den pn-Übergang 31 in Sperrichtung vorspannt.

Nach einer Weiterbildung des erfindungsgemäßen Verfahrens wird damit Protonen bestrahlte Halbleiterbauelement anschließend während eines Zeitraumes von zum Beispiel 10 Stunden in einer Temperatur von etwa 220°C getempert. Damit wird erreicht, daß sich die nach der Temperung erhaltenen Parameter des Halbleiterbauelementes in Betrieb, das heißt bei einer niedrigeren Betriebstemperatur, nicht mehr verändern.

## Patentansprüche

1. Verfahren zur Erhöhung der Spannungsfestigkeit eines scheibenförmigen Halbleiterbauelements, mit vier aufeinanderfolgenden Schichten: einer Emitterschicht (1) eines ersten Leitfähigkeitstyps, einer Basisschicht (2) eines zweiten Leitfähigkeitstyps, einer Basisschicht (3) des ersten Leitfähigkeitstyps und einer zweiten Emitterschicht (4) des zweiten Leitfähigkeitstyps, bei dem die Emitterschicht des ersten Leitfähigkeitstyps eine Verbindung mit einer Kathode (K) und die Emitterschicht des zweiten Leitfähigkeitstyps eine Verbindung mit der Anode (A) aufweist und bei dem ein erster pn-Übergang (7) zwischen der Basisschicht des ersten Leitfähigkeitstyps und der Basisschicht des zweiten Leitfähigkeitstyps und ein zweiter pn-Übergang (8) zwischen der Basisschicht des ersten Leitfähigkeitstyps und der Emitterschicht des zweiten Leitfähigkeitstyps besteht,
**dadurch gekennzeichnet,**
daß ein zentraler aktiver Bereich (LBz) des Halbleiterbauelements mit einer Bestrahlungsmaske derart abgedeckt wird, daß lediglich in einem Bereich (LBr) von positiv abgeschrägten Randabschlüssen (12, 13), die zur Absenkung der Oberflächenfeldstärke vorhanden sind, eine Protonenbestrahlung des halbleiterbauelementes erfolgt, daß eine im Vergleich zur Dicke der Basisschicht des ersten Leitfähigkeitstyps relativ dünne Zone (16, 17) im lateralem Bereich (LBr) außerhalb der Bestrahlungsmaske und vertikal zwischen dem ersten und zweiten pn-Übergang bewirkt wird, wobei die dünne Zone (16) eine im Vergleich zur Basisschicht des ersten Leitfähigkeitstyps reduzierte Ladungsträgerlebensdauer aufweist und die Bestrahlungsenergie der Protonenstrahlung so bemessen wird, daß sich die dünne Zone mit der reduzierten Ladungsträgerlebensdauer außerhalb der infolge der Sperrspannung am ersten und/oder zweiten pn-Übergang (7, 8) sich aufbauenden Raumladungszone befindet.

## Claims

1. Method of increasing the dielectric strength of a semiconductor component in wafer form, with four successive layers: an emitter layer (1) of a first conductivity type, a base layer (2) of a second conductivity type, a base layer (3) of the first conductivity type and a second emitter layer (4) of the second conductivity type, in which the emitter layer of the first conductivity type has a connection to a cathode (K) and the emitter layer of the second conductivity type has a connection to the anode (A), and in which there is a first pn junction (7) between the base layer of the first conductivity type and the base layer of the second conductivity type and a second pn junction (8) between the base layer of the first conductivity type and the emitter layer of the second conductivity type, characterized in that a central active region (LBz) of the semiconductor component is covered with an exposure mask in such a way that proton exposure of the semiconductor component takes place only in a region (LBr) of positively bevelled edge connections (12, 13) which are provided in order to reduce the surface field strength, in that a relatively thin zone (16, 17) in comparison with the thickness of the base layer of the first conductivity type is created in the lateral region (LBr) outside the exposure mask and vertically between the first and second pn junctions, the thin zone (16) having a reduced charge-carrier lifetime compared with the base layer of the first conductivity type and the exposure energy of the proton radiation being designed such that the thin zone with the reduced charge-carrier lifetime lies outside the space-charge zone created as a result of the reverse blocking voltage at the first and/or second pn junction (7, 8).

## Revendications

1. Procédé pour augmenter la tenue en tension d'un composant semi-conducteur en forme de disques, avec quatre couches successives: une couche émetteur (1) d'une première nature de conductivité, une couche base (2) d'une deuxième nature de conductivité, une couche base (3) de la première nature de conductivité et une couche émetteur (4) de la deuxième nature de conductivité, la couche émetteur de la première nature de conductivité comportant une liaison avec une cathode (K), la couche émetteur de la deuxième nature de conductivité comportant une liaison avec une anode (A), une première jonction pn (7) existant entre la couche base de la première nature de conductivité et la couche base de la deuxième nature de conductivité et une deuxième jonction pn (8) existant entre la couche base de la première nature de conductivité et la couche émetteur de la deuxième nature de conductivité,
**caractérisé par le fait**
qu'une zone centrale active (LBz) du composant semi-conducteur est recouverte d'un masque d'irradiation de telle sorte qu'une irradiation aux protons du composant semi-conducteur ne se produit que dans une zone (LBr) de bordures biseautées positivement (12, 13), qui sont prévues pour diminuer la force de champ en surface, par le fait qu'une zone (16, 17), relativement mince par rapport à l'épaisseur de la couche base de la première nature de conductivité, est produite dans la zone latérale (LBr) à l'extérieur du masque d'irradiation et verticalement entre la première et la deuxième jonction pn, la zone mince (16) présentant, par rapport à la couche base de la première nature de conductivité, une durée de vie des porteurs de charge réduite et l'énergie d'irradiation aux protons étant dimensionnée de telle sorte que la zone mince avec la durée de vie des porteurs de charge réduite se trouve à l'extérieur de la zone de charge d'espace qui s'établit, en raison de la tension de blocage, à la première et/ou à la deuxième jonction pn (7, 8).
